# EUROPEAN PATENT APPLICATION

(11) **EP 1 386 726 A1**
(43) Date of publication of application: **04.02.2004**
(21) Application number: 02425499.7
(22) Date of filing: 31.07.2002
(51) Int. Cl.: B32B 31/20, H05K 3/46

(54) **A process and device for pressing multi-layered cards**

(71) Applicant: Fox Technologies S.r.l., 20059 Vimercate (MI) (IT)
(72) Inventor: Ferri, Carlo, 21040 Carnago (VA) (IT)
(74) Representative: Tansini, Elio Fabrizio

(57) **Abstract**

A pressing process for multi-layered cards comprises the step of placing at least one multi-layered card of composite material (S) between a rest surface (2) and a deformable diaphragm (3) substantially lying parallel to the rest surface (2) on the opposite side with respect to the card (S) to delimit a first sealingly closed chamber (4). Subsequently, a negative differential pressure is created in the first chamber (4) to cause deformation of the diaphragm (3) and association of same with the multi-layered card (S). The multi-layered card (S) is heated while maintaining the negative differential pressure, until polymerization of the resin forming the separation layers (P) which is part of the card itself (S), is caused.

## Description

The present invention relates to a process and a device for pressing multi-layered cards.

By the term "multi-layered cards" it is intended cards formed of a multiplicity of superposed layers, of composite material for example, constituting the card structure, that are mutually joined by sheets of plastic resin interposed therebetween.

In the present specification particular reference will be made to multi-layered cards for printed circuits, without however excluding applications of different nature.

Multi-layered cards of the above type are employed for producing printed circuits commonly used on computers, telephones, or electronic apparatus of several types.

It is known that a card for printed circuits is normally formed by coupling two or more support layers in mutual superposed relationship, said layers being made of a composite material such as fibre glass for example and being usually referred to as "inner layers", on which respective conductive paths are disposed that are formed following known and not further described processes.

Between a support layer and the subsequent one, a separation layer is interposed which essentially consists of a film of plastic resin normally filled with glass fibres and currently referred to as "pre-peg" which performs a dual function of insulator and bonding agent.

The support layers are suitably aligned to make the conductive paths fit in a precise manner.

The card is finally submitted to a pressing and heating process causing polymerization of the resin present in the separation layers, steady union of the layers and stiffening of the assembly.

Devices for pressing multi-layered cards for printed circuits are known that consist of hydraulically-operated mechanical presses formed of two hot plates made of steel and movable in mutual approach, between which several superposed cards are placed. The plates are contained in a chamber in which the vacuum is created to avoid air bubbles being entrapped in the resin.

Heat-transmission from the plates to all points of the card pack takes place by conduction through the adjacent cards.

As a result, temperature increase in the separation layers that are in the middle of the pack takes place in longer periods of time than the separation layers close to the plates.

In addition, since heat transmission is not instantaneous at all points of a plane parallel to the plate plane, there are regions belonging to the same layer that have different temperatures.

When there is a temperature increase, the utilised resins first reach the state of a viscous gel and subsequently harden by polymerization. Viscosity of the resin in a gelatinous state depends on the temperature-increase velocity: the greater the velocity at which the temperature increase takes place, the smaller the viscosity reached by the resin which therefore has a greater fluidity.

Possible temperature unevennesses in the card pack and consequent unhomogeneousness in the plastic-resin viscosity can give rise, by effect of the force exerted by the press plates, to different deformations of the resin and, as a result, misalignment of the layers of each card. The card is consequently irreparably damaged and must be discarded.

In addition, since temperature in the inner layers cannot be quickly increased without the risk of burning the layers close to the plates, due to the low viscosity of the resin present in the central separation layers, a drastic increase in the specific pressure until values as high as 20-30 kg/cm² is required which will result in a worse quality of the material.

To partly solve these problems, presses consisting of several plates have been conceived that have intermediate heating matrices placed between groups of cards. But for production purposes, several cards must be necessarily disposed between two intermediate matrices and consequently the above problem arises again.

In addition, since the intermediate matrices are floating, the viscosity unevenness even causes inclination of the matrices that move down where they find a more fluid resin.

In both the above described known solutions the force applied by the press must be set based on the sizes of each individual card, to keep pressure exerted thereon within a correct range of values. In fact, the smaller the extension of the card surface is, the smaller the force applied by the press must be, so that pressure, i.e. the force/surface ratio, should be the correct one.

Finally, due to the presence of structures for supporting and moving the press, the above mentioned devices of the known art are bulky, heavy and energy-consuming.

Accordingly, it is an object of the present invention to propose a process and a device for pressing multi-layered cards capable of solving the above mentioned problems.

In particular, it is an object of the present invention to propose a process and a device for pressing multi-layered cards capable of making multi-layered cards of higher quality than those obtained with the known art.

It is a further object of the present invention to make a pressing device for multi-layered cards which is of simple structure, compact and inexpensive.

The foregoing and further objects that will become more apparent in the following description are achieved by a pressing process for multi-layered cards comprising the features set out in claim 1, and a pressing device for multi-layered cards comprising the features set out in claim 10.

Further features and advantages will be best understood from the detailed description of a process for pressing multi-layered cards in accordance with the present invention and a preferred but not exclusive embodiment of a pressing device for multi-layered cards which is the object of the present invention too.

The invention will be described hereinafter with reference to the accompanying drawings, given by way of non-limiting example, in which:
- Fig. 1 is a diagrammatic sectional view of a pressing device for multi-layered cards in accordance with the present invention;
- Fig. 2 is a diagrammatic perspective view of a multi-layered card;
- Fig. 3 is a diagrammatic sectional view of the device shown in Fig. 1 associated with a multi-layered card, in a first operating step;
- Fig. 4 is a diagrammatic sectional view of the device in Fig. 1 associated with a multi-layered card, in a second operating step;
- Fig. 5 is a diagrammatic sectional view of the device in Fig. 1 associated with a multi-layered card, in a third operating step.

With reference to the drawing, a pressing device for multi-layered cards in accordance with the present invention has been generally identified by reference numeral 1.

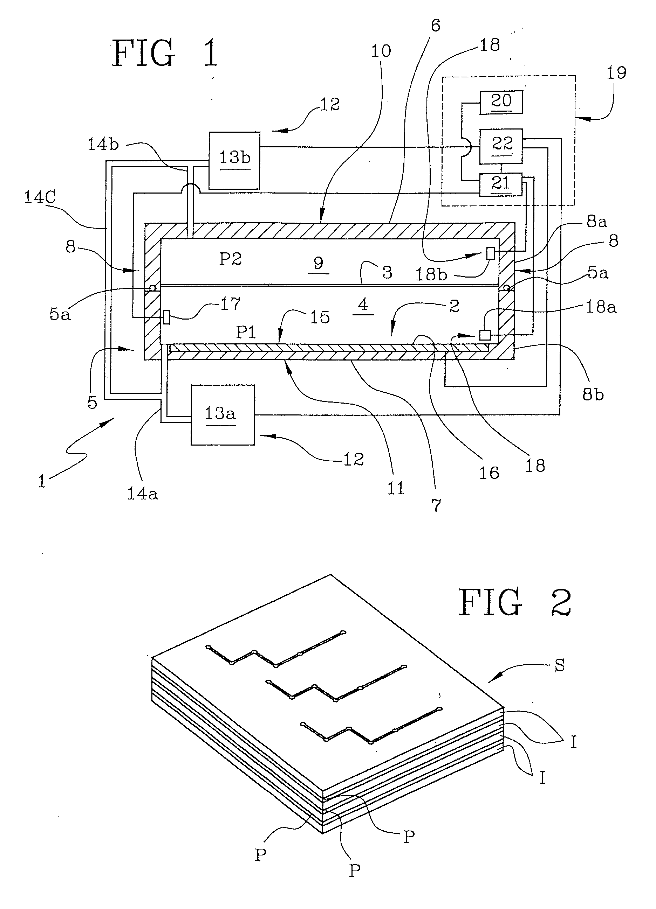

Device 1 comprises a rest surface 2 on which at least one multi-layered card 3 is placed. For the sake of clarity, referring particularly to Fig. 2, by multi-layered card it is intended a card made up of a plurality of support layers I alternated with a plurality of separation layers at least partly made of resin P.

In particular, the invention relates to multi-layered cards employed in making printed circuits, in which the support layers usually referred to as "inner layers", can be made of a composite material for example, comprising glass fibres incorporated into a resinous matrix and the separation layers P, usually referred to as "pre-peg", can also incorporate glass fibres or other electrically insulating material into the resin of which they are made.

Preferably, a plurality of cards S are piled up and laid down on surface 2 to be all together submitted to pressing.

An elastically deformable diaphragm 3 disposed parallel to the rest surface 2 is mounted above the rest surface 2, spaced apart therefrom.

The elastically deformable diaphragm 3 together with the rest surface 2 confine a first sealingly closed chamber 4 for holding the multi-layered card S or a group of multi-layered cards S.

Preferably, as shown in the accompanying figures, the deformable diaphragm 3 is contained in a box-shaped body 5 of parallelepiped shape with a rectangular base defined by an upper wall 6, a lower wall 7 and a side wall 8.

The rest surface 2 is formed on the lower wall 7 of the box-shaped body 5.

Diaphragm 3 is placed between the lower wall 7 and upper wall 6 and is peripherally associated with the side wall 8 to delimit the first chamber 4 at the lower part thereof and a second chamber 9 at the upper part. The second chamber 9 defines an environment adjoining diaphragm 3 on the opposite side with respect to chamber 4.

In the preferred embodiment herein shown, to enable easy positioning of card S on the rest surface 2, the box-shaped body 5 is divided into an upper portion 10 and a lower portion 11, which are removably associable with each other by actuating members neither shown nor further described because they can be made in any known manner.

A sealing element 5a is disposed between the two portions 10, 11.

The upper portion 10 comprises the upper wall 6 of the box-shaped body 5 and a first part 8a of the side wall 8. The lower portion 11 comprises the lower wall 7 and a second part 8b of the side wall 8.

Advantageously, the deformable diaphragm 3 is associated with the upper portion 10. In particular, diaphragm 3 is mounted on the first part 8a of the side wall 8.

Device 1 further comprises appropriate means 12 to vary pressure P1 in the first chamber 4 with respect to pressure P2 of the environment adjoining diaphragm 3 on the opposite side with respect to the first chamber 4. In the preferred embodiment herein shown, this environment is defined by the second chamber 9.

The means to vary pressure P1 in the first chamber 4 with respect to pressure P2 in the second chamber 9 is able to create a negative differential pressure in the first chamber 4 with respect to the second chamber 9, to cause deformation of diaphragm 3 and adhesion of same to the multi-layered card or cards S.

Difference in pressure between the two chambers 4, 9 can be obtained following different methods. Preferably, the negative differential pressure is obtained through pressure P1 reduction in the first chamber 4 by pulling air out of said chamber.

For the purpose, device 1 comprises a first pump 13a operatively active in the first chamber 4. As diagrammatically shown in Fig. 1, the first pump 13a is connected to the first chamber 4 through a duct 14a inserted in the lower wall 7 of the box-shaped structure 5, for example.

Simultaneously with pulling air out of the first chamber 4, or as an alternative to this process, a negative differential pressure can be created in the first chamber 4 by increasing pressure P2 in the second chamber 9.

For the purpose, the second chamber 9 can be connected to a second pump 13b through a respective duct 14b inserted in the upper wall 6 of the box-shaped structure 5, for example.

In addition, an auxiliary duct 14c is also preferably provided which, upon interposition of a shutoff solenoid valve (not shown), connects the second chamber 9 with the first pump 13a.

Alternatively, the second pump 13b and possibly the first pump 13a too, can be able both to pull out air to create the vacuum and to admit air under pressure, so that the pressurization and depressurization cycle can be varied based on the characteristics of the materials of the cards to be joined.

Preferably, the work cycle first involves a step of pulling out air from both chambers 4, 9 to avoid possible air bubbles being entrapped in the material forming cards S, during the subsequent steps. During this step, pressure in the first chamber 4 keeps the same as that in the second chamber 9 without stresses being transmitted to diaphragm 3.

Subsequently, by a further solenoid valve not shown for example, atmospheric-pressure air is admitted to the second chamber 9 so as to cause deformation of diaphragm 3, adhesion of diaphragm 3 to cards S and uniform pressure distribution on said cards.

In a subsequent step, the air pressure P2 in the second chamber 9 can be increased to values in the order of 10 bars, depending on requirements.

Device 1 further comprises heating means 15 operatively associated with the first chamber 4, to increase temperature of the resin present in the separation layers P of cards S during pressing, so as to cause passage of the resin to the gelatinous phase and subsequent polymerization of same.

Advantageously, the heating means 15 comprises an electric resistance 16 mounted on the rest surface 2. Preferably, resistance 16 is of the "skin" type, i.e. it is defined by a resistive metal foil bearing on or applied to the rest surface 2, to come into direct contact with one of the multi-layered cards S.

This type of resistance practically does not show any thermal inertia and enables quick heating and cooling of the cards S themselves.

Preferably, the step of creating a negative differential pressure in the first chamber 4 and the step of heating the multi-layered card S are carried out simultaneously.

Alternatively, the step of heating the multi-layered card S is carried out after the step of creating a negative differential pressure in the first chamber 4.

To control the pressurization or depressurization cycles and heating cycles, device 1 may comprise a series of temperature and/or pressure sensors 18 for example, that transmit the detected signals to a control unit 19.

The control unit 19 is further connected to the heating means 15, the first pump 13a and second pump 13b to start or shut down the heating means 15, first pump 13a and second pump 13b based on the signals detected by sensors 17. 18.

In more detail, as diagrammatically shown in Fig. 1, device 1 can be provided with a temperature sensor 17 operatively active in the first chamber 4 to detect a temperature correlated with heating of the separation layers P.

In addition, a first pressure sensor 18a is active in the first chamber 4 and a second pressure sensor 18b is active in the second chamber 9 to detect the respective air pressures P1, P2 in the two chambers 4, 9.

Advantageously, the control unit comprises data input means 20, a processing unit 21 and a command unit 22 by which appropriate temperature and pressure curves can be set depending on the sizes, number and materials of the cards to be treated.

A specific example of a process to be carried out with the device in accordance with the present invention is described in the following.

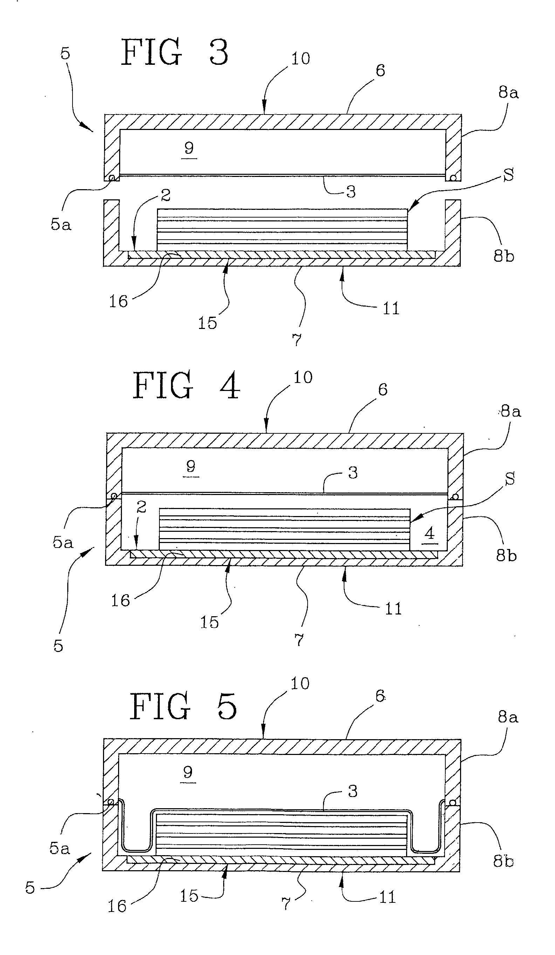

A stack of cards S is laid down in the lower portion 11 of the box-shaped structure 5 in contact with the resistive foil 16 (Fig. 3).

Subsequently, the upper portion 10 is sealingly laid on the lower portion 11 to define, below the second chamber 9, the first chamber 4 holding the stack of cards S.

An operator, through the data input means 20, programs the control unit 19 and, in an automatic manner, the command unit 22 operates the first pump 13a, second pump 13b and resistance 16 to carry out a pressing cycle.

In particular, pump 13a sucks air simultaneously from both chambers 4, 9 (Fig. 4) to remove possible air bubbles incorporated in the separation layers P before exerting a pressure on the stack of cards S.

Subsequently, while the first chamber 4 is maintained sealingly closed, atmospheric-pressure air is admitted to the second chamber 9 to cause deformation of diaphragm 3 against the card stack. The higher pressure P2 present in the second chamber 9 with respect to the first chamber pressure P1 exerts a thrust action on cards S which is uniformly distributed (Fig. 5).

In addition, at this point of the process pressurized air can be introduced into the second chamber 9 through the second pump 13b to increase the force exerted on cards S.

While diaphragm 3 is pressed on the stack of cards S, the control unit 19 causes activation of resistance 16 that immediately gets hot and heats the card S directly resting thereon and, by conduction, the adjacent cards S too.

By varying the duration of the gaps during which the control unit 19 supplies current to resistance 16, cards S are allowed to be submitted to given temperature curves.

At the end of the heating step, the second pump 13b can carry out ventilation of the second chamber 9 to cool the multi-layered card S.

Finally, after the atmospheric pressure has been restored in both chambers 4, 9, the box-shaped structure 5 is opened to draw the pressed cards S out.

The present invention achieves important advantages.

First of all, the pressing device and process in accordance with the present invention enable multi-layered cards of high quality to be obtained with a minimum number of discarded cards. In particular, making cards by the process of the present invention ensures a uniform pressure and temperature distribution in all the separation layers present in the cards avoiding occurrence of phenomena of mutual sliding between the support layers.

Use of the deformable diaphragm and exploitation of the pressure differences enables the device to adapt itself to cards of different sizes without requiring setting of the press loads based on the contact surface between the press plates and the card stack, as it happened in the machines of the known art.

In addition, the pressing device in accordance with the present invention is much more compact and of much simpler structure than the devices of the known art. As a result, a more reduced room is required for installation of same.

Due to the simpler installation of the device of the present invention, an energy saving is ensured which reaches 70% as compared with energy consumption in traditional devices, the number of the produced cards being the same.

It should be also recognized that the greater efficiency obtained with the invention enables pressing to be carried out by applying to the card specific pressures of much lower value than required in the known art. In spite of that, it is possible to transmit temperature gradients to the cards being processed that are even 10 times and more higher than those obtainable in the known art. This situation appears to be very advantageous in connection with control of the fluidity of the resinous material forming the separation layers between the cards in the transitory gelation step preceding polymerization of said layers. Consequently, the possibility of utilizing separation layers P having a reduced percentage of resin with respect to the known layers emerges, which will bring about important advantages in terms of production costs.

## Claims

1. A pressing process for multi-layered cards, **characterized in that** it comprises the following steps:
- placing at least one multi-layered card (S) having a plurality of support layers (I) alternated with a plurality of separation layers at least partly made of resin (P), between a rest surface (2) for said card (S) and a deformable diaphragm (3); the diaphragm (3) substantially lying parallel to the rest surface (2) on the opposite side with respect to the card (S) to delimit a first sealingly closed chamber (4);
- creating a negative differential pressure in the first chamber (4) with respect to an environment (9) adjoining the diaphragm (3). on the opposite side from said first chamber (4), to cause deformation of the diaphragm (3) and association of said diaphragm (3) with the multi-layered card (S);
- heating said at least one multi-layered card (S) while maintaining the negative differential pressure until polymerization of the resin forming the separation layers (P) is caused.

2. A process as claimed in claim 1, **characterized in that** the step of creating a negative differential pressure in the first chamber (4) is carried out through pressure reduction in said first chamber (4).

3. A process as claimed in claim 1 or 2, **characterized in that** the step of creating a negative differential pressure in the first chamber (4) is carried out by pulling air out of said first chamber (4).

4. A process as claimed in claim 1, **characterized in that** the step of creating a negative differential pressure in the first chamber (4) is carried out by pressure increase in the environment (9) adjoining the diaphragm (3) on the opposite side from said first chamber (4).

5. A process as claimed in claim 1, **characterized in that** it further comprises, before the step of creating a negative differential pressure in the first chamber (4), the step of pulling out air simultaneously from the first chamber (4) and the environment (9) adjoining the diaphragm (3) on the side opposite to said first chamber (4).

6. A process as claimed in claim 5, **characterized in that** the step of creating a negative differential pressure in the first chamber (4) is carried out by pressure increase in the environment (9) adjoining the diaphragm (3) on the side opposite to said first chamber (4).

7. A process as claimed in claim 1, **characterized in that** the step of creating a negative differential pressure in the first chamber (4) and the step of heating said at least one multi-layered card (S) are carried out simultaneously.

8. A process as claimed in claim 1, **characterized in that** the step of heating said at least one multi-layered card (S) is carried out after the step of creating a negative differential pressure in the first chamber (4).

9. A process as claimed in claim 1, **characterized in that**, after the step of heating said at least one multi-layered card (S), it further comprises the step of ventilating the environment (9) adjoining the diaphragm (3) on the opposite side from said first chamber (4), to cool the multi-layered card (S).

10. A pressing device for multi-layered cards, **characterized in that** it comprises:
- a rest surface (2) for at least one multi-layered card (S);
- a deformable diaphragm (3) disposed parallel to the rest surface (2) and spaced apart therefrom to delimit a first chamber (4) for holding said at least one multi-layered card (S) and an environment (9) adjoining said diaphragm (3) on the opposite side from the first chamber (4) ;
- means (12) to vary pressure (P1) in the first chamber (4) with respect to pressure (P2) in the environment adjoining the diaphragm (3) on the side opposite to the first chamber (4);
- heating means (15) operatively associated with said first chamber (4).

11. A device as claimed in claim 10, **characterized in that** it further comprises a box-shaped body (5) defined by an upper wall (6), a lower wall (7) and a side wall (8); the rest surface (2) being formed on said lower wall (7); the deformable diaphragm (3) being placed between the lower wall (7) and upper wall (6) to delimit a second chamber defining the environment (9) adjoining the diaphragm (3) on the side opposite to said first chamber (4) .

12. A device as claimed in claim 11, **characterized in that** the box-shaped body (5) comprises:
- an upper portion (10) including the upper wall (6) and a first part (8a) of the side wall (8);
- a lower portion (11) including the lower wall (7) and a second part (8b) of the side wall (8); the upper portion (10) being removably associable with the lower portion (11).

13. A device as claimed in claim 12, **characterized in that** the deformable diaphragm (3) is mounted on the first part (8a) of the side wall (8).

14. A device as claimed in claim 11, **characterized in that** the means (12) for varying pressure (P1) in the first chamber (4) with respect to pressure (P2) in the environment (9) adjoining the diaphragm (3) on the side opposite to the first chamber (4) comprises a first pump (13a) operatively active in the first chamber (4).

15. A device as claimed in claim 14, **characterized in that** the means (12) for varying pressure (P1) in the first chamber (4) with respect to pressure (P2) in the environment (9) adjoining the diaphragm (3) on the side opposite to the first chamber (4) comprises a second pump (13b) operatively active in the second chamber (9).

16. A device as claimed in claim 10, **characterized in that** the heating means (15) comprises an electric resistance (16) mounted on the rest surface (2).

17. A device as claimed in claim 16, **characterized in that** the electric resistance (16) is defined by a metal foil bearing on the rest surface (2) to come into direct contact with one of the multi-layered cards (S).

18. A device as claimed in claim 15, **characterized in that** it further comprises:
- at least one first pressure sensor (18a) operatively active in the first chamber (4);
- at least one second pressure sensor (18b) operatively active in the second chamber (9);
- a control unit (19) connected to the first pressure sensor (18a), second pressure sensor (18b), heating means (12), first pump (13a) and second pump (13b), to start or shut down the heating means (12), first pump (13a) and second pump (13b), based on the signals received from the first pressure sensor (18a) and second pressure sensor (18b).
